# EUROPEAN PATENT APPLICATION

(11) **EP 3 438 747 A1**
(43) Date of publication of application: **06.02.2019**
(21) Application number: 17774117.0
(22) Date of filing: 07.03.2017
(51) Int. Cl.: G03F 7/033, G03F 7/00, G03F 7/11

(54) **RELIEF PRINTING ORIGINAL PLATE FOR ROTARY LETTERPRESS PRINTING**

(30) Priority: 29.03.2016 JP 2016065283; 17.08.2016 JP 2016159809
(71) Applicant: Toyobo Co., Ltd., Osaka-shi Osaka 530-8230 (JP)
(72) Inventor: NAKAZAWA, Eri, Okayama-shi Okayama 704-8194 (JP); NAKAMORI, Masahiko, Okayama-shi Okayama 704-8194 (JP)
(74) Representative: Vossius & Partner Patentanwälte Rechtsanwälte mbB
(86) International application number: PCT/JP2017/009026
(87) International publication number: WO 2017/169572

(57) **Abstract**

A relief printing original plate for rotary letterpress printing wherein at least an adhesive layer, a photosensitive resin layer and a cover film are successively layered on a support, wherein the photosensitive resin layer contains at least a synthetic rubber-based polymer, a photopolymerizable unsaturated compound and a photopolymerization initiator, and Shore A hardness of a surface of the photosensitive resin layer after photo-curing is 80 to 95. Preferably, the synthetic rubber-based polymer is a hydrophobic polymer obtained from a water-dispersible latex having a weight-average gelation degree of 50 to 80%. Preferably, the photosensitive resin layer contains 20 to 70% by mass of the synthetic rubber-based polymer. The relief printing original plate is suitably used for a rotary printing machine of a center drum type.

## Description

### Technical Field of the Invention

The present invention relates to a relief printing original plate for rotary letterpress printing having a photosensitive resin layer wherein a mounting property is good, a thickening by printing pressure is not noted and an ink transfer of solid image is excellent.

### Background Art

In a printing method of a photosensitive resin relief, there are two kinds which are a letterpress printing using an oily ink (nonaqueous ink) and a flexographic printing using an aqueous ink, and an appropriate one is used depending upon a type of ink and print. The flexographic printing is such a printing method wherein a lowly viscous and quickly drying ink is printed by means of a high speed printing with a low printing pressure using a soft printing plate having a high impact resilience and being represented by synthetic rubber, and it is used for printing on a film or a corrugated cardboard (for example, see Patent Document 1). On the contrary, the letterpress printing is also called a typographic printing and is a method wherein a highly viscous oily ink is transferred by pushing the ink with a high printing pressure using a hard printing plate (for example, see Patent Document 2). In a print prepared by the letterpress printing, the ink is swollen out by the high printing pressure and becomes dark so as to form a marginal. Accordingly, the letterpress printing allows a vigorous printing of letters, and it is called a printing method suitable for books.

In those printing methods using the photosensitive resin relief, it has been known that a printing quality may greatly vary depending upon a hardness and an impact resilience of the photosensitive resin layer. A letterpress printing plate is inferior in the ink transfer because its photosensitive resin layer is hard. On the contrary, a flexographic printing plate is superior in the ink transfer because a hardness of its photosensitive resin layer is low. However, when the soft flexographic printing plate is used just as it is for the letterpress printing, the printing plate is deformed due to the high printing pressure, resulting in the big thickening by printing pressure. As such, a letterpress printing plate having both advantages of the excellent ink transfer and the less problem of the thickening by printing pressure has not been proposed yet.

In addition, with regard to a layered product of the relief printing plate for rotary letterpress printing, a big problem of "curling-in" still remains. A printing plate prepared from a printing original plate is used after being adhered to a plate cylinder or the like using a double-sided adhesive tape. When the printing plate curls in, an edge of, particularly, a solid part becomes a state of being lifted. Therefore, a printing process with a high pressure is inevitable for amending the lifted state. As a result, a fine image is deformed with the pressure whereby a very big thickening is formed.

Moreover, there has been resulted a problem that the curling-in plate is broken when it is mounted to a plate cylinder. Against the curling-in of the printing plate, there have been investigated several measures for mitigating the curling-in such as that a rigidity of a support is enhanced and that a cushion layer is formed on a support. However, any of them has not been satisfactory. There has been a demand for a photosensitive resin original plate for relief printing wherein the curling-in is solved by improving the photosensitive resin itself. The curling-in of a printing plate is apt to happen especially when the plate is stored at a low temperature in wintertime. Accordingly, there has been a necessity for solving this problem in order to obtain a stable print in wintertime.

### Prior Art Documents

### Patent Documents

Patent Document 1: Japanese Patent Application Laid-Open (JP-A) No. 2002-196492
Patent Document 2: Japanese Patent Application Laid-Open (JP-A) No. 2001-42528

### Disclosure of the Invention

### Problem that the Invention is to Solve

The present invention has been created in view of the current status of the prior art. An object of the present invention is to provide a relief printing original plate for rotary letterpress printing wherein a mounting property in a plate cylinder is good, a thickening by printing pressure is not noted and an ink transfer is excellent.

### Means for Solving the Problem

In order to achieve such an object, the inventors have conducted eager investigations. As a result, they have found that all of the problems of mounting property, thickening by printing pressure and ink transfer in a letterpress rotary printing can be solved when a printing process is carried out at a low printing pressure (being out of a common knowledge in a conventional letterpress printing) in a printing plate having a softer surface hardness than a conventional letterpress printing plate using a photosensitive resin layer containing a synthetic rubber-based polymer. Up to now, it has been believed that, in a highly viscous ink for letterpress, the ink is hardly transferred in a good state unless being printed with a high printing pressure. However, it has now been unexpectedly found that the ink transfer is excellent even when a letterpress printing is conducted at a low printing pressure using a rubber-based printing plate having a lower hardness than usual. Further, when the rubber-based printing plate having a low hardness is adopted, there is such a tendency that a deformation of the printing plate by the printing pressure is apt to happen and that a halftone dot printing is apt to result in a dark print. However, it has now been found that a thickening in printing is not achieved and a highlight halftone dot printing property is enhanced when a low printing pressure condition being in a printable limit is adopted without a necessity of such high printing pressure as in the conventional letterpress printing. It has been further found that the problem of curling-in is also mitigated by using the rubber-based printing plate having a lower hardness and little curing shrinkage.

The present invention has been achieved on the basis of the above findings and has the constitutions of the following (1) to (6).
(1) A relief printing original plate for rotary letterpress printing wherein at least an adhesive layer, a photosensitive resin layer and a cover film are successively layered on a support, characterized in that the photosensitive resin layer contains at least a synthetic rubber-based polymer, a photopolymerizable unsaturated compound and a photopolymerization initiator, and that Shore A hardness of a surface of the photosensitive resin layer after photo-curing is 80 to 95.
(2) The relief printing original plate for rotary letterpress printing according to (1), wherein the synthetic rubber-based polymer is a hydrophobic polymer obtained from a water-dispersible latex having a weight-average gelation degree of 50 to 80%.
(3) The relief printing original plate for rotary letterpress printing according to (1) or (2), wherein the photosensitive resin layer contains 20 to 70% by mass of the synthetic rubber-based polymer.
(4) The relief printing original plate for rotary letterpress printing according to any of (1) to (3), wherein an ink or a coating agent used for the rotary letterpress printing is a nonaqueous ink selected from any of a UV ink and an oily ink or is a nonaqueous coating agent of a UV varnish.
(5) The relief printing original plate for rotary letterpress printing according to any of (1) to (4), wherein a thickness of the photosensitive resin layer is 300 to 850 µm.
(6) The relief printing original plate for rotary letterpress printing according to any of (1) to (5), wherein it is used for a rotary printing machine of a center drum type. Advantages of the Invention

In accordance with the present invention, it is possible to provide a relief printing original plate for rotary letterpress printing wherein an ink transfer is excellent, a problem of a thickening of printing does not happen and a mounting property in a plate cylinder is good.

### Best Mode for Carrying Out the Invention

Hereinafter, the relief printing original plate for rotary letterpress printing of the present invention will be illustrated in detail.

The relief printing original plate for rotary letterpress printing of the present invention has such a structure that at least an adhesive layer, a photosensitive resin layer and a cover film are successively layered on a support. The relief printing original plate for rotary letterpress printing of the present invention is characterized in that, the photosensitive resin layer contains at least a synthetic rubber-based polymer, a photopolymerizable unsaturated compound and a photopolymerization initiator, and that Shore A hardness of a surface of the printing original plate is 80 to 95. Particularly, the relief printing original plate according to the present invention is characterized in that, the Shore A hardness of its surface is soft as compared with that in a conventional one for letterpress printing (100 or higher) and is hard as compared with that in a conventional one for flexographic printing (about 70).

The support to be used for the printing original plate of the present invention is preferably made from a material being flexible and having a superior dimension stability, and examples thereof include: a support made of metal, such as steel, aluminum, copper and nickel, and a film made of a thermoplastic resin, such as a polyethylene terephthalate film, a polyethylene naphthalate film, a polybutylene terephthalate film and a polycarbonate film. Among these, the polyethylene terephthalate film, which has a superior dimension stability and a sufficiently high viscoelasticity, is in particular preferably used. A thickness of the support is preferably 50 to 350 µm, and more preferably 80 to 250 µm, from the viewpoints of mechanical properties, shape stability and handling characteristics upon producing a printing plate.

The adhesive layer used in the printing original plate of the present invention is arranged for enhancing an adhesion between the support and the photosensitive resin layer. As to the adhesive layer, use of already-known ingredients for the adhesive layer is possible. There is no particular limitation therefor as far as it has such a sufficient adhesive property that it is not released during the printing. As to the ingredients for the adhesive layer, there are exemplified a copolymerized polyester having a hydroxyl group in a terminal, a compound having two or more isocyanate groups and upon necessity, photopolymerizable monomer and other additives. The adhesive property can be achieved by arranging a layer which is thermally cross-linked with a compound having two or more isocyanate groups.

With regard to the photosensitive resin layer used in the printing original plate of the present invention, it at least contains, as essential ingredients, a synthetic rubber-based polymer, a photopolymerizable unsaturated compound and a photopolymerization initiator. Materials and a compounding rate thereof are selected in such a manner that Shore A hardness (apparent Shore A hardness) of a surface of the photosensitive resin layer of the printing original plate after photo-curing is 80 to 95. To be more specific, the surface hardness can be mainly adjusted by means of a type and a compounding amount of the synthetic rubber-based polymer used for the photosensitive resin layer and by means of a thickness of the photosensitive resin layer. The Shore A hardness is usually measured in a thickness of 6 mm because of a pushing operation using a front end of the pushing needle. However, in the present invention, in order to measure a hardness in a state of a printing plate, the Shore A hardness of solid part of the printing plate forming a relief image is directly measured. Accordingly, the Shore A hardness in the present invention stands for an apparent Shore A hardness obtained by measuring the surface hardness of the printing plate.

The synthetic rubber-based polymer is used for imparting an appropriate rubber elasticity to the photosensitive resin layer. As to the synthetic rubber-based polymer, rubber ingredients which have been known already can be used. Incidentally, the synthetic rubber-based polymer exhibits little water absorption and moisture release and, therefore, curing and shrinking thereof are small whereby, when it is used for a printing plate, the problem of curling-in hardly happens. As to the synthetic rubber-based polymer, it is preferred to use a hydrophobic polymer obtained from a water-dispersible latex having a weight-average gelation degree of 50 to 80%.

Examples of the hydrophobic polymer obtained from the water-dispersible latex include: water-dispersible latex polymers, such as polybutadiene latex, styrene-butadiene copolymer latex, acrylonitrile-butadiene copolymer latex, polychloroprene latex, polyisoprene latex, polyurethane latex, methylmethacrylate-butadiene copolymer latex, vinylpyridine polymer latex, butyl polymer latex, thiokol polymer latex and acrylate polymer latex; and polymers obtained by copolymerizing another component, such as acrylic acid and methacrylic acid, therewith. Among these, water-dispersible latex polymers having a butadiene skeleton or an isoprene skeleton in molecular chains are preferably used from viewpoints of hardness and rubber elasticity. More specifically, polybutadiene latex, styrene-butadiene copolymer latex, acrylonitrile-butadiene copolymer latex, methylmethacrylate-butadiene copolymer latex and polyisoprene latex are preferably used. The latex needs to be designed so that its existence is confirmed as independent fine particles.

The weight-average gelation degree of the water dispersible latex is preferred to be 50 to 80% and more preferred to be 65 to 80%. Although this gelation degree can be satisfied by a single kind of latex, it can be also satisfied by mixing of plural kinds of latex having various gelation degrees. When the weight-average gelation degree of the latex is less than the above-mentioned range, it may not be possible to fully suppress an aggregation and a unification of microfine particles of the latex upon making into a printing original plate while, when it exceeds the above range, an abrasion resistance may lower due to a decrease in an elongation. The gelation degree of the latex may be measured by a method mentioned in the Japanese Laid-Open Patent No. 2010/23492 A. Amount in terms of % by weight of ingredients which are insoluble in a toluene solution after the drying is defined as a gelation degree. When two or more kinds of latexes are used, the gelation degree shall show a weighted average of the gelation degrees of those latexes.

The synthetic rubber-based polymer may contain a rubber elastomer other than the latex so as to impart a rubber elasticity to the photosensitive resin composition. Specific examples of the rubber elastomer include butadiene rubber, nitrile butadiene rubber, acrylic rubber, epichlorohydrin rubber, urethane rubber, isoprene rubber, styrene isoprene rubber, styrene butadiene rubber, ethylene-propylene copolymer and chlorinated polyethylene. Each of them may be used solely or two or more of them may be used jointly. Among them, butadiene rubber and nitrile butadiene rubber are preferred, and butadiene rubber is the most preferred.

A compounding amount of the synthetic rubber-based polymer in the photosensitive resin layer is preferred to be 20 to 70% by mass and more preferred to be 30 to 60% by mass. When the compounding amount is within the above range, a surface hardness of the printing plate may easily be set within the range of the present invention.

As to the photopolymerizable unsaturated compound, already-known photopolymerizable unsaturated compounds can be used. It is particularly preferred to contain a photopolymerizable oligomer and a photopolymerizable monomer.

The photopolymerizable oligomer is a polymer having a number-average molecular weight of 1,000 to 10,000 which has been obtained by binding an ethylenic unsaturated group to terminal and/or side chain of a conjugated diene-based polymer. Examples of such a conjugated diene-based copolymer include a butadiene polymer, an isoprene polymer, a chloroprene polymer, a styrene-chloroprene copolymer, an acrylonitrile-butadiene copolymer, an acrylonitrile-isoprene copolymer, a methyl methacrylate-isoprene copolymer, a methyl methacrylate-chloroprene copolymer, a methyl acrylate-butadiene copolymer, a methyl acrylate-isoprene copolymer, a methyl acrylate-chloroprene copolymer, an acrylonitrile-butadiene-styrene copolymer and an acrylonitrile-chloroprene-styrene copolymer. Among these, a butadiene polymer, an isoprene polymer and an acrylonitrile-butadiene copolymer are preferable, and a butadiene polymer and an isoprene polymer are particularly preferable from viewpoints of rubber elasticity and photocurability.

The photopolymerizable monomer preferably comprises at least one kind of alkyl methacrylate and, particularly preferably, it comprises a C_{8∼18} and straightly linear alkyl methacrylate. Specific examples thereof include alkyl (meth)acrylate such as methyl (meth)acrylate, ethyl (meth)acrylate, propyl (meth)acrylate, butyl (meth)acrylate, isoamyl (meth)acrylate, 2-ethylhexyl (meth)acrylate, lauryl (meth)acrylate or stearyl (meth)acrylate; cycloalkyl (meth)acrylate such as cyclohexyl (meth)acrylate; halogenated alkyl (meth)acrylate such as chloroethyl (meth)acrylate or chloropropyl (meth)acrylate; alkoxyalkyl (meth)acrylate such as methoxyethyl (meth)acrylate, ethoxyethyl (meth)acrylate or butoxyethyl (meth)acrylate; and phenoxyalkyl (meth)acrylate such as phenoxyethyl (meth)acrylate or nonylphenoxyethyl (meth)acrylate. Particularly preferred examples include n-lauryl methacrylate, alkyl (C_{12∼13}) methacrylate, tridecyl methacrylate and alkyl (C_{12∼15}) methacrylate.

A compounding amount of the photopolymerizable unsaturated compound in the photosensitive resin layer is preferred to be 1 to 50% by mass and more preferred to be 5 to 40% by mass. When the compounding amount is less then the above range, a resulting relief may become fragile and a flexibility may be deteriorated while, when it exceeds the above range, a resulting crude plate may become too soft and a handling ability thereof may be deteriorated.

The photopolymerization initiator can be any compound as far as it is capable of causing a polymerizable carbon-carbon unsaturated group to polymerize by light irradiation. Among them, a preferable one is a compound which has a function of generating a radical through self decomposition or hydrogen extraction caused by light absorption. Specific examples thereof include benzoin alkyl ethers, benzophenones, anthraquinones, benzylketals, acetophenones, diacetyls and the like. A compounding amount of the photopolymerization initiator in the photosensitive resin layer is preferred to be 0.1 to 10% by mass and more preferred to be 0.5 to 8% by mass. When the compounding amount is less than the above range, an initiation efficiency may decrease and an image reproducibility may become inferior while, when it exceeds the above range, a sensitivity may become higher and a control of an exposure time may become difficult.

The photosensitive resin layer of the present invention may also contain optional ingredients such as plasticizer, thermal polymerization preventer, dye, pigment, ultraviolet absorber, perfume or antioxidant in addition to the above essential ingredients which are the synthetic rubber-based polymer, photopolymerizable unsaturated compound and photopolymerization initiator. A thickness of the photosensitive resin layer is preferred to be 300 to 850 µm. This thickness is a bit thin as compared with a thickness in a conventional relief printing original plate. Such a thin thickness of the photosensitive resin layer contributes to a realization of the printing original plate having a high hardness.

The cover film to be used for the printing original plate of the present invention is preferably made from a material being flexible and having a superior dimension stability, and examples thereof include: a film made of a thermoplastic resin, such as a polyethylene terephthalate film, a polyethylene naphthalate film and a polybutylene terephthalate film. Among these, the polyethylene terephthalate film, which has a superior dimension stability and a sufficiently high viscoelasticity, is in particular preferably used. A thickness of the cover film is preferably 50 to 350 µm, and more preferably 80 to 300 µm, from the viewpoints of mechanical properties, shape stability and handling characteristics upon producing a printing plate.

Although a method for producing the relief printing original plate of the present invention is not particularly limited, it can be produced, for example, by the following manner. Thus, firstly, a release-adjusting layer and an adhesion-preventing layer are laminated on a cover film whereby a layered product is previously formed. On the other hand, ingredients constituting the photosensitive resin layer are previously prepared and a mixture thereof is applied onto a support to which an adhesive layer is attached so as to form another layered product. When those two layered products are laminated under pressure and/or heating in such a manner that the photosensitive resin layer becomes adjacent to the adhesion-preventing layer whereupon a printing original plate is obtained.

With regard to the relief printing original plate of the present invention, it is also possible to produce a printing plate by a method using a negative film or by means of a computer-to-plate technique. A CTP printing original plate for the computer-to-plate technique consists of at least a support, a photosensitive resin layer and a heat-sensitive mask layer. In the relief printing original plate of the present invention, it is possible to reproduce a fine image of the printing plate by means of the computer-to-plate technique.

The heat-sensitive mask layer is composed of carbon black (which is a material having a function for absorbing infrared laser rays to convert them into heat and a function for blocking ultraviolet rays) and a dispersion binder therefor. Moreover, desired components except for these, such as a pigment dispersant, a filler, a surfactant or a painting aid, may be contained therein within such a range as not to impair the effects of the present invention.

It is preferable to provide a peelable flexible cover film on the heat-sensitive mask layer so as to protect the printing original plate. Examples of the preferable peelable flexible cover film include a polyethylene terephthalate film, a polyethylene naphthalate film and a polybutylene terephthalate film. However, such a protective film is not absolutely necessary.

In addition, a protective layer may be arranged between the photosensitive resin layer and the heat-sensitive mask layer. The protective layer is arranged in order to prevent a mass transfer between the photosensitive resin layer and the heat-sensitive mask layer and also to prevent a polymerization-inhibition due to oxygen in the photosensitive resin layer. The protective layer is not particularly limited but may be constituted by using any polymer being soluble or insoluble in water. A layer thickness of a protective layer is preferred to be 0.2 µm to 3.0 µm and more preferred to be 0.2 µm to 1.5 µm.

There is also no particular limitation for a method for producing a relief printing plate from the obtained relief printing original plate. For example, a production method as mentioned hereunder may be adopted. Thus, firstly, the cover film is removed from the relief printing original plate. Then, a mask film having a transparent image part is tightly adhered and laid on the adhesion-preventing layer. Then, an active light ray is applied thereon for an exposure whereupon an exposed part is cured and becomes insoluble. As to the active light ray, there may be used a light source such as a high-pressure mercury lamp, a super-high-pressure mercury lamp, a metal halide lamp, a xenon lamp and a chemical lamp wherein a main wavelength is usually 300 to 400 nm. After the exposure, an unexposed parts are dissolved and removed by using an appropriate solvent such as, preferably, water or, particularly, neutral water whereupon the plate is quickly developed within a short time so as to obtain a printing plate (relief plate) . As to a development system, it is preferred to use a spray-type development apparatus, a brush-type development apparatus, etc. A thickness of the relief printing plate is preferred to be 400 to 1200 µm and more preferred to be 700 to 1000 µm.

Now, a method for manufacturing a CTP printing plate from the CTP printing original plate of the present invention will be explained. When a protective film is present, the protective film is firstly removed from the photosensitive printing original plate. Thereafter, the heat-sensitive mask layer is imagewise-irradiated with an IR laser so that a mask is formed on the photosensitive resin layer. Preferable examples of the IR laser include an ND/YAG laser (1064 nm) and a diode laser (for example, 830 nm). A laser system appropriate for the computer to plate technique is commercially available, and, for example, CDI SpArk (manufactured by Esko-Graphics Co., Ltd.) may be used. This laser system includes a rotation cylinder drum used for holding a printing original plate, an IR laser irradiating device and a layout computer. Image information is directly transferred from the layout computer to the laser device.

After the image information has been written in the heat-sensitive mask layer, an active light ray is applied onto an entire surface of the photosensitive printing original plate via the mask. This process may be carried out with the plate attached to the laser cylinder; however, a method is generally used in which, after the plate has been removed from the laser device, the irradiation process is carried out by using a commonly-used irradiation unit having a flat plate shape. This method is more advantageous in that even a plate size out of the standard can be appropriately handled. Examples of the active light ray include an ultraviolet ray having a wavelength in a range from 150 to 500 nm, in particular, from 300 to 400 nm. Examples of its light source include: a low-pressure mercury lamp, a high-pressure mercury lamp, a super-high pressure mercury lamp, a metal halide lamp, a xenon lamp, a zirconium lamp, a carbon arc lamp and an ultraviolet-ray fluorescent lamp. Thereafter, the irradiated plate is developed so as to obtain a printing plate. The developing process can be carried out by using a commonly-used developing unit.

The relief printing original plate of the present invention is suitable for using in a rotary letterpress printing. As to a material to be printed for a thing to be printed, an ink or a coating agent is used. As to the ink, a nonaqueous ink selected from a UV ink and an oily ink is exemplified. As to the coating agent, a nonaqueous coating agent of a UV vanish is exemplified. The relief printing original plate of the present invention has a low surface hardness in spite of a fact that the plate is used for a letterpress printing. Due to this feature, it exhibits a good mounting property to a plate cylinder, has no thickening by printing pressure and shows an excellent ink transfer. Accordingly, the relief printing original plate of the present invention is very suitable for conducting the letterpress printing in a rotary printing machine of a center drum type. In a rotary letterpress printing of a center drum type, a plate cylinder and a pressure cylinder rotate according to a run of paper. Therefore, a printing speed is high and a printing precision is also high. Accordingly, the center drum type is suitable for the printing plate prepared from the relief printing original plate of the present invention.

### Examples

Advantageous effects of the present invention will now be specifically illustrated by way of the following Examples although the present invention is not limited thereto. Evaluations of each characteristic property data were done in accordance with the following methods.

### (Shore A hardness of the surface)

Each of the resulted printing plates was stored at 20°C and 65% RH for seven days and then Shore A hardness of a surface of a solid part (fully exposed part) of each printing plate was measured at a room temperature (25°C) using a Shore type durometer (Shore A type) manufactured by Zwick. As to the Shore type durometer (Shore A type) manufactured by Zwick, a product equipped with a stand exclusively therefor was used. The Shore A hardness was measured by placing the printing plate on a rest made of metal.

### (Curing-in degree)

On a polyethylene terephthalate film (support) in 125 µm thickness wherein a polyurethane adhesive layer prepared from polyester resin and isocyanate compound was applied thereon with a layer thickness of 20 µm, a photosensitive resin layer is formed, so as to prepare photosensitive resin original plates of the Examples and the Comparative Examples. Each of the resulting photosensitive resin original plate was exposed for 10 minutes by using a printer of A2 size (chemical lamp of Mitsubishi) manufactured by Nippon Denshi Seiki and cutting was done thereafter whereupon a sample of 10 cm diameter was prepared. After that, the sample was developed by using a developing apparatus to give a relief wherein whole surface thereof was exposed to light. The resulting relief image of 10 cm diameter was stored at 20°C and 32% RH for seven days so as to prepare a sample for evaluating a curling-in degree. The resulting evaluation sample was allowed to stand on an experimental stand having a horizontal plane and the curling-in degree was measured. The curing-in degree is the highest position of the relief warped by being deformed to an inner side, and expressed by a height (cm) from the horizontal plane.

### (Printing property of a highlight part)

### (a) Evaluation of rotary printing machine

The printing property of the highlight part was evaluated by using each of the resulting printing plate. A rotary printing machine P-20 (manufactured by Sanjo Kikai) was used as a printing machine, Best Cure Indigo (manufactured by T&K TOKA) was used as an ink, and Gross PW-8K (manufactured by Lintec) was used as a thing to be printed. The evaluation of printing was conducted in such a manner that a printing pressure (a pressure between the plate and the thing to be printed) was gradually raised and a pressure at which a blurring of a solid part disappeared was adopted as a proper pressure. Further, an ink feed amount was adjusted so that an ink concentration of the solid part was made 1.7 abs. A screen dot concentration of 150 lines-3% under the proper pressure was measured using CCDOT 4 (manufactured by SDG). The measurement was conducted at five points for each thing to be printed. A degree of dot gain was judged based on an average value at the five points. Incidentally, the printing pressure is expressed by a distance (in µm) between a plate cylinder and a pressure cylinder which has been narrowed by using a kiss touch (the very minimum printing pressure necessary for initiating the printing of the image) as an indicator.
○○: a halftone dots area rate is 10% or less
○: the halftone dots area rate is more than 10% and is 15% or less
Δ: the halftone dots area rate is more than 15% and is 20% or less
×: the halftone dots area rate is more than 20%

### (b) Evaluation of rotary printing machine of a center drum type

The printing property of the highlight part was evaluated by using each of the resulting printing plate. A rotary printing machine (manufactured by Ko-Pack) was used as a printing machine, Best Cure Indigo (manufactured by T&K TOKA) was used as an ink, and Gross PW-8K (manufactured by Lintec) was used as a thing to be printed. The evaluation of printing was conducted by adopting 50 µm as a proper pressure. Further, an ink feed amount was adjusted so that an ink concentration of the solid part was made 1.7 abs. A screen dot concentration of 150 lines-3% under the proper pressure was measured using CCDOT 4 (manufactured by SDG). The measurement was conducted at five points for each thing to be printed. A degree of dot gain was judged based on an average value at the five points. Incidentally, the printing pressure is expressed by a distance (in µm) between a plate cylinder and a pressure cylinder which has been narrowed by using a kiss touch (the very minimum printing pressure necessary for initiating the printing of the image) as an indicator.
○○: a halftone dots area rate is 10% or less
○: the halftone dots area rate is more than 10% and is 15% or less
Δ: the halftone dots area rate is more than 15% and is 20% or less
×: the halftone dots area rate is more than 20%

### (Ink transfer)

A solid part of each printing plate was observed by naked eye and the ink transfer was evaluated according to the following judging criteria.
○: a color was not uneven but uniform
Δ: an uneven color was partially noted
×: the uneven color was noted as a whole

### Example 1

### Preparation of photosensitive resin composition A

Polybutadiene latex (Nippol LX111NF, manufactured by Nippon Zeon, weight-average gelation degree: 86%) (42.2 parts by mass (solid basis)), 7.2 parts by mass (solid basis) of acrylonitrile-butadiene copolymer latex (Nippol SX1503, manufactured by Nippon Zeon, weight-average gelation degree: 0%) and 80 parts by mass of toluene were heated at 60°C to prepare a solution in which rubber was dissolved. This solution was allowed to cool down to a room temperature. Then, 5 parts by mass (solid basis) of hydrophilic polymer (PFT-4 manufactured by Kyoeisha Chemical), 20 parts by mass of oligobutadiene acrylate (ABU-4 manufactured by Kyoeisha Chemical) , 9 parts by mass of trimethylolpropane trimethacrylate, 9 parts by mass of lauryl methacrylate, 6 parts by mass of a plasticizer (B2000, manufactured by Nippon Petrochemical), 1.5 parts by mass of a photopolymerization initiator (Irgacure 651) and 0.1 part by mass of hydroquinone monomethyl ether as a polymerization inhibitor were added thereto together with 15 parts by mass of toluene. They were mixed in a container and toluene and water were removed *in vacuo* therefrom together with kneading at 80°C using a kneader. Details of the resulting photosensitive resin composition A are shown in Table 1.

### Preparation of relief printing original plate

Between a support prepared by coating a polyester-based adhesive layer in 20 µm thickness on a polyethylene terephthalate film of 125 µm thickness and a cover film prepared by coating a protective layer (polyvinyl alcohol) and a heat-sensitive mask layer (butyral resin in which carbon black was dispersed) on a polyethylene terephthalate film in 100 µm thickness, the photosensitive resin composition A was inserted in such a manner that the adhesive layer and the protective layer contact with the photosensitive resin composition. Then, the resulting laminate was heated and pressed at 100°C and 15 MPa using a heating/pressing machine whereupon a photosensitive resin original plate was prepared.

### Preparation of printing plate from the relief printing original plate

The above photosensitive resin original plate was subjected to a back exposure for 15 seconds by using a fluorescent lamp for an ultraviolet ray (10R manufactured by Philips) wherein an illuminance at 350 nm was 8.0 w/m². Then, the cover film was detached. Then, an image containing at least 150 lines and 3% of halftone dots was subjected to abrasion to a resin plate heat sensitive mask layer using an IR laser irradiator. After that, a main exposure was conducted by using the same fluorescent lamp for ultraviolet ray. The plate was developed for seven minutes by using a developing apparatus. Then the developed plate was strained, dried at 60°C for ten minutes, subjected to an after exposure for five minutes by using the same fluorescent lamp for ultraviolet ray, and subjected to a surface treatment by irradiating with a sterilization lamp for five minutes so as to give a relief for evaluation having a relief image wherein there were reproduced the halftone dots of 150 lines and 3%.

The resulting printing plate was evaluated. Incidentally, the highlight printing property was evaluated by means of (a) rotary printing machine. Details of the printing plate and of the evaluated result thereof are shown in Table 2.

### Examples 2 to 15 and Comparative Examples 1 to 3

As to Examples 2 to 14 and Comparative Examples 1 to 3, the same operation as in Example 1 was conducted except that ingredients and constitutions were changed as shown in Tables 1 and 2 whereupon the photosensitive resin compositions B to I, relief printing original plates and printing plates were prepared and subjected to evaluations. Details of the photosensitive resin composition are shown in Table 1. Details and evaluation results of the printing plate are shown in Table 2. In Example 15, the printing plate prepared in Example 1 was used and the evaluation for highlight printing property was conducted by means of (b) rotary printing machine of a center drum system. Incidentally, the polybutadiene used in the photosensitive resin compositions H and I was Nipol BR 1220 manufactured by Nippon Zeon and a weight-average gelation degree thereof was 0% . Further, in Examples 2 to 4, the printing evaluation was conducted by increasing the printing pressure. In other Examples, the printing evaluation was conducted under the proper pressure. The printing pressure is expressed by a distance (in µm) between a plate cylinder and a pressure cylinder which has been narrowed by using a kiss touch as an indicator.

### Comparative Example 4

### Preparation of photosensitive resin composition J

ε-Caprolactam (500 parts by mass), 575 parts by mass of Nylon salt of 2.70 parts by mass of N-(2-aminoethyl)piperazine with 305 parts by mass of adipic acid and 40 parts by mass of N- (2-aminoethyl)piperazine as an agent for making the terminal into an amino group (as well as an adjusting agent for polymerization degree) were subjected to a melt polycondensation in an autoclave so as to give a light yellow, transparent and alcohol-soluble copolymerized Nylon oligomer (average molecular weight: ca. 3050) wherein a specific viscosity was 1.40 and both terminals were substantially primary and/or tertiary amino group (s) . Separately, 750 parts by mass of polypropylene glycol (average molecular weight: 1000) was reacted with 300 parts by mass of hexamethylene diisocyanate so as to give an urethane oligomer having isocyanate groups substantially in both terminals. After that, 92 parts by mass of the copolymerized Nylon oligomer prepared as shown above was dissolved in 200 parts by mass of methanol and, at 50°C, 18 parts by mass of the above urethane oligomer was gradually poured into a Nylon oligomer solution with stirring. The reaction between the both finished within about 15 minutes. Viscosity of the reaction solution was about 180 poises. This light yellow and transparent solution was cast onto a Petri dish coated with Teflon (registered trademark), and methanol was removed by evaporation so as to give a polymer (water-soluble polyether urea urethaneamide) having an amide bond, an urethane bond and an urea bond in a molecule. The resulting polymer was a light yellow, semitransparent, soft and elastic polymer wherein a softening point was 85 to 95°C and a specific viscosity was 2.20.

The above-prepared polymer (55 parts by mass) was dissolved in 100 parts by mass of methanol. To this solution were added 5 parts by mass of adipic acid (which forms an ammonium salt with terminal amino group and basic tertiary nitrogen of a piperazine ring in a main chain of the above polymer so as to make the above polymer water-soluble), 25 parts by mass of epoxy ester (200PA), 12 parts by mass of n-butylbenzene sulfonamide, 1 part by mass of photopolymerization initiator (Irgacure 651) and 0.1 part by mass of hydroquinone monomethyl ether so as to give a solution of the photosensitive resin composition. This solution was flown into a Petri dish coated with Teflon (registered trade mark) and methanol was removed therefrom by evaporation in a dark place followed by drying in *vacuo* at 40°C for a whole day and night more whereupon a sheet of the photosensitive resin composition J was prepared.

### Preparation of relief printing original plate

This sheet was adhered to a support prepared by coating an adhesive composition containing an ultraviolet absorber in a film thickness of 20 µm onto a polyester film in 125 µm thickness. Further, an upper side of the sheet was applied to a polyester film of 125 µm thickness coated with a protective layer (polyvinyl alcohol) and a heat-sensitive mask layer (butyral resin in which carbon black was dispersed), so that a coated side thereof contacts with the photosensitive resin composition J. The resulting laminate was thermally pressed at 100°C whereupon a crude plate of a sheet-form layered product was prepared.

### Preparation of printing plate from the relief printing original plate

After detaching the cover film of the photosensitive resin original plate, an image containing at least 150 lines and 3% of halftone dots was subjected to abrasion to a resin plate heat-sensitive mask layer. Next, the above photosensitive resin original plate was subjected to a main exposure by using a fluorescent lamp for an ultraviolet ray (10R manufactured by Philips) wherein an illuminance at 350 nm was 8.0 w/m². The plate was developed for two minutes by using a developing apparatus. Then the developed plate was strained, dried at 60°C for ten minutes, subjected to an after exposure for one and half minutes by using the same fluorescent lamp for ultraviolet ray so as to give a relief for evaluation having a relief image wherein there were reproduced the halftone dots of 150 lines and 3%.

The resulting printing plate was evaluated. Details of the photosensitive resin composition are shown in Table 1, and details of the printing plate and of the evaluated result thereof are shown in Table 2.

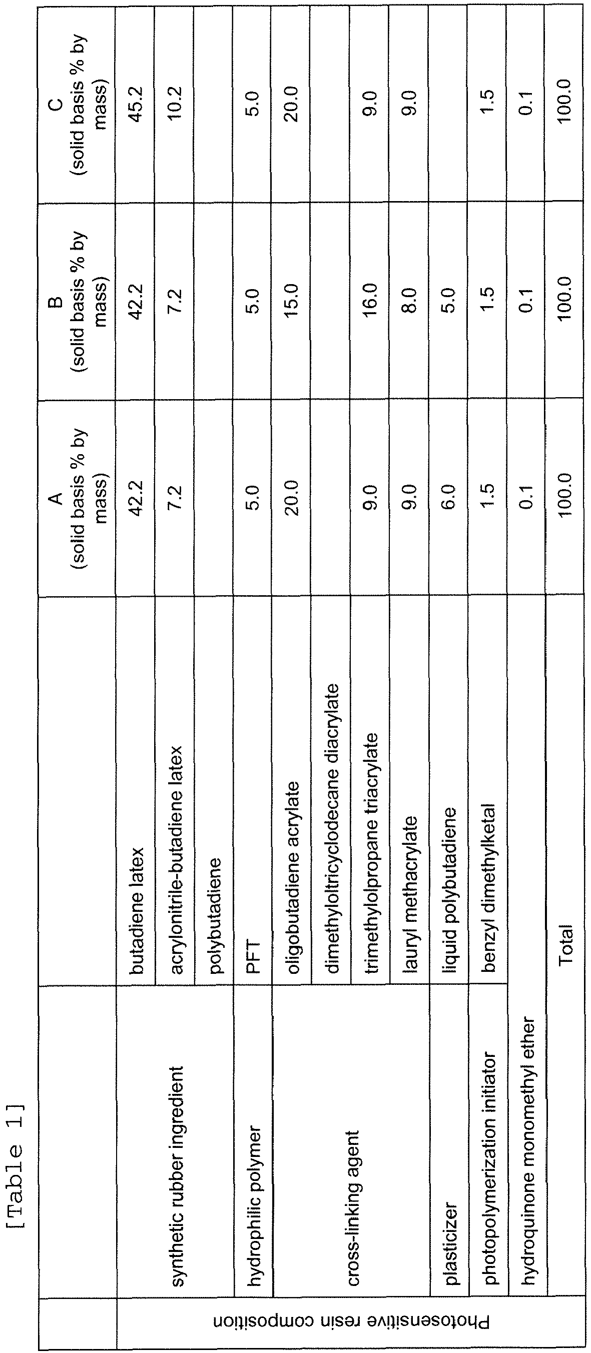

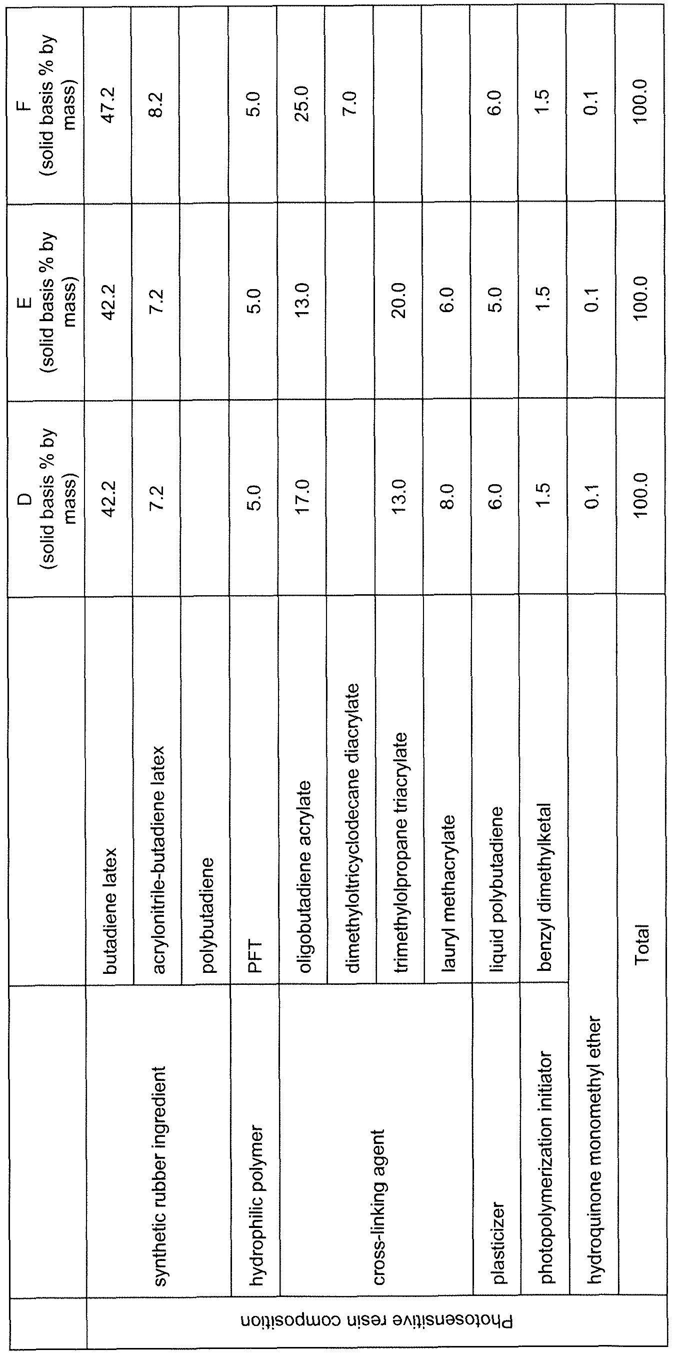

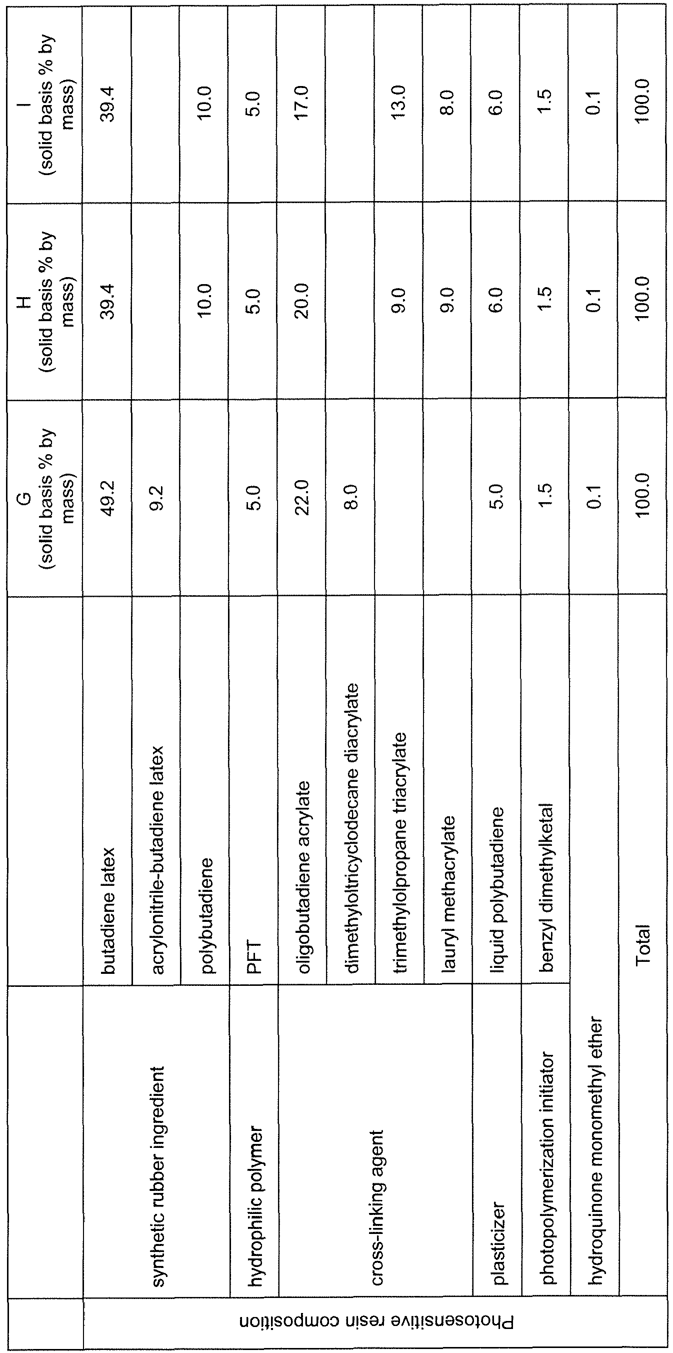

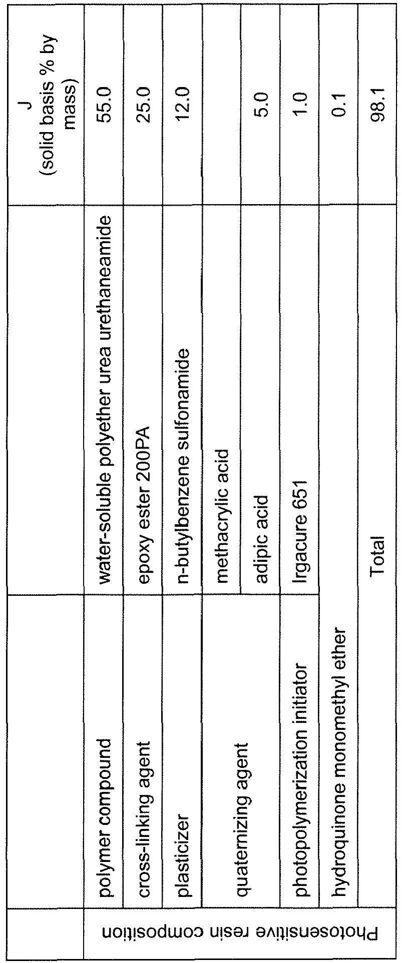

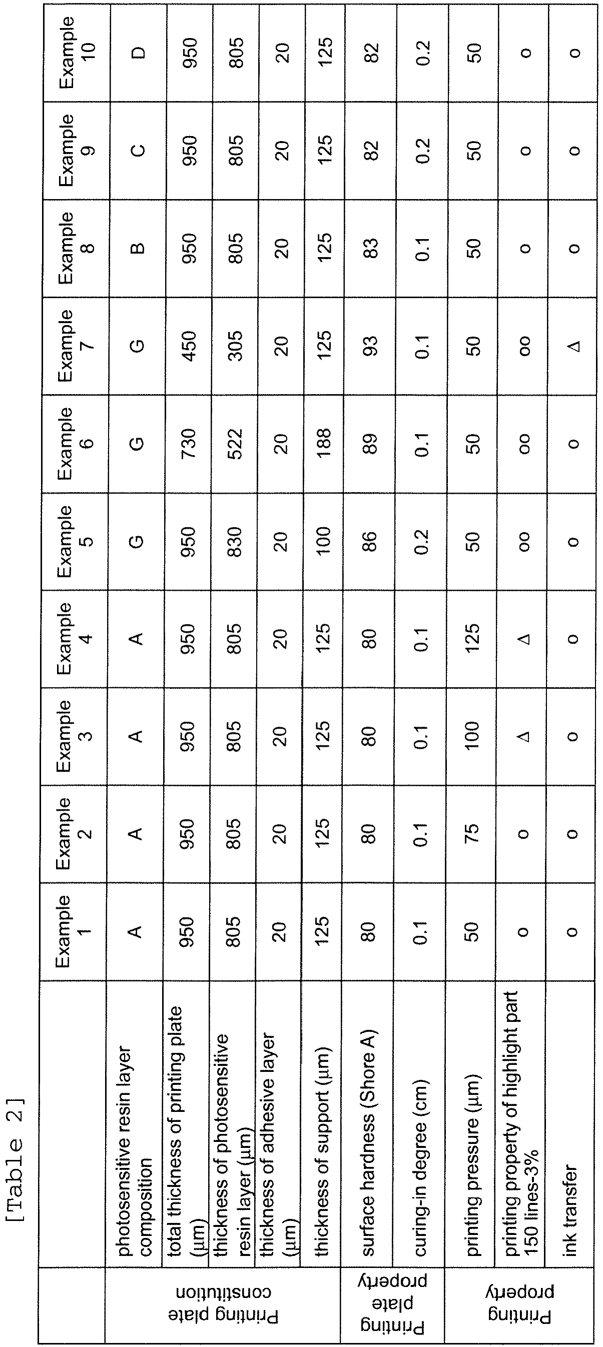

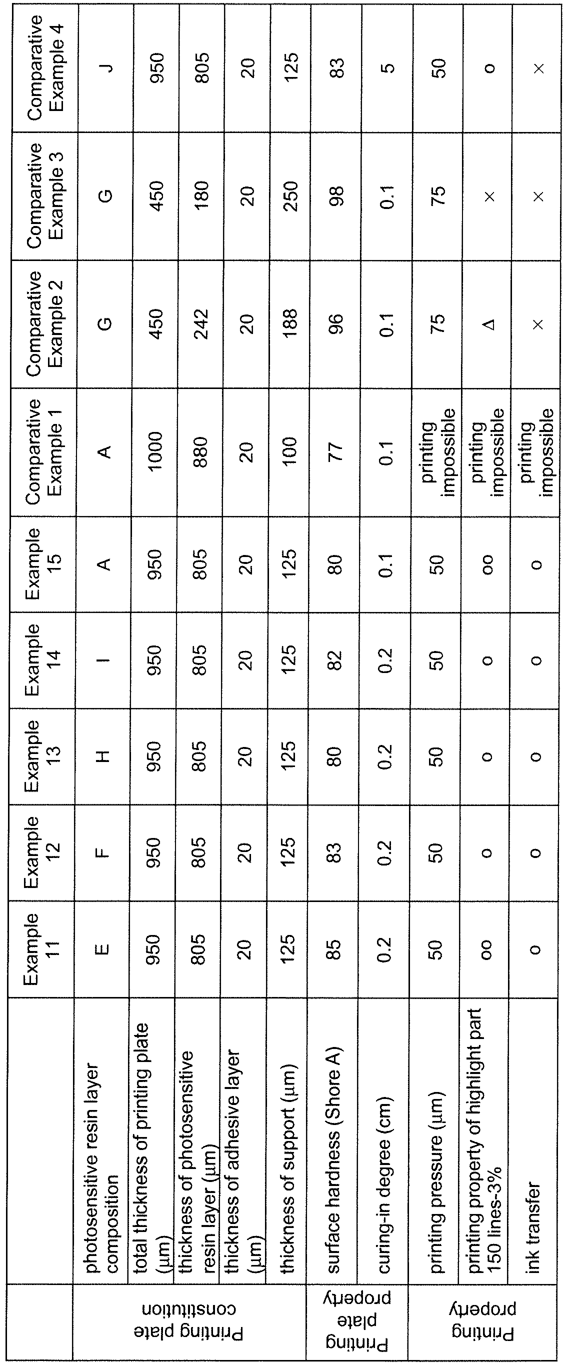

As will be apparent from the evaluation result of Table 2, the printing plate obtained from the printing original plates of Examples 1 to 15 satisfying the conditions stipulated by the present invention did not result in a problem of curling-in, showed no thickening by printing pressure, was excellent in an ink transfer and had a high highlight printing property. Particularly in Examples 1 to 3, it was confirmed that the highlight printing property was enhanced when a printing pressure was made lower than a usual pressure for letterpress (150 µm) . Moreover, in Example 15 wherein the printing was conducted by a rotary printing machine of a center drum type, the highlight printing property was significantly improved as compared with the case wherein the printing was done using a usual rotary printing machine. On the contrary, in Comparative Examples 1 to 4 wherein the condition stipulated by the present invention was not satisfied, there happened a problem in any of the curling-in, the highlight printing property and the ink transfer.

### Industrial Applicability

The relief printing original plate of the present invention solves all of the problems in the rotary letterpress printing which are the mounting on plate cylinder, thickening by printing pressure and ink transfer. Accordingly, it is quite suitable for the case wherein a letterpress printing is conducted using a rotary printing machines of a center drum type.

## Claims

1. A relief printing original plate for rotary letterpress printing wherein at least an adhesive layer, a photosensitive resin layer and a cover film are successively layered on a support, **characterized in that** the photosensitive resin layer contains at least a synthetic rubber-based polymer, a photopolymerizable unsaturated compound and a photopolymerization initiator, and that Shore A hardness of a surface of the photosensitive resin layer after photo-curing is 80 to 95.

2. The relief printing original plate for rotary letterpress printing according to claim 1, wherein the synthetic rubber-based polymer is a hydrophobic polymer obtained from a water-dispersible latex having a weight-average gelation degree of 50 to 80%.

3. The relief printing original plate for rotary letterpress printing according to claim 1 or 2, wherein the photosensitive resin layer contains 20 to 70% by mass of the synthetic rubber-based polymer.

4. The relief printing original plate for rotary letterpress printing according to any of claims 1 to 3, wherein an ink or a coating agent used for the rotary letterpress printing is a nonaqueous ink selected from any of a UV ink and an oily ink or is a nonaqueous coating agent of a UV varnish.

5. The relief printing original plate for rotary letterpress printing according to any of claims 1 to 4, wherein a thickness of the photosensitive resin layer is 300 to 850 µm .

6. The relief printing original plate for rotary letterpress printing according to any of claims 1 to 5, wherein it is used for a rotary printing machine of a center drum type.
